# DEMANDE DE BREVET EUROPEEN

(11) **EP 4 579 665 A1**
(43) Date de publication de la demande: **02.07.2025**
(21) Numéro de dépôt: 23220729.0
(22) Date de dépôt: 29.12.2023
(51) Int. Cl.: G11C 16/04

(54) **CIRCUIT ÉLECTRONIQUE ADAPTÉ POUR CHARGER OU LIRE UNE STRUCTURE MÉMOIRE À GRILLE FLOTTANTE**

(71) Demandeur: The Swatch Group Research and Development Ltd, 2074 Marin (CH)
(72) Inventeur: CASAGRANDE, Arnaud, 2014 Bôle (CH); AREND, Jean-Luc, 2035 Corcelles (CH); ACOVIC, Alexandre, 1027 Lonay (CH)
(74) Mandataire: ICB SA

(57) **Abrégé**

Un aspect de l'invention concerne un circuit électronique disposant d'une structure mémoire à grille flottante, qui comprend depuis une première borne d'entrée (T) un premier condensateur (1) à grille flottante (FG) de grande dimension, et depuis une seconde borne d'entrée (B) un second condensateur (2) à grille flottante (FG) de dimension inférieure au premier condensateur (1). Le premier condensateur (1) est relié en série par l'intermédiaire de sa grille flottante (FG) à la grille flottante (FG) du second condensateur (2). Le circuit électronique est agencé pour lire et charger la structure mémoire à grille flottante. Le premier condensateur est converti sous la forme d'un transistor de type MOS pour servir directement de transistor de lecture de la structure mémoire à grille flottante.

## Description

### Domaine technique de l'invention

La présente invention se rapporte à un circuit électronique adapté pour charger ou lire une structure mémoire à grille flottante faisant partie du circuit électronique.

### Arrière-plan technologique

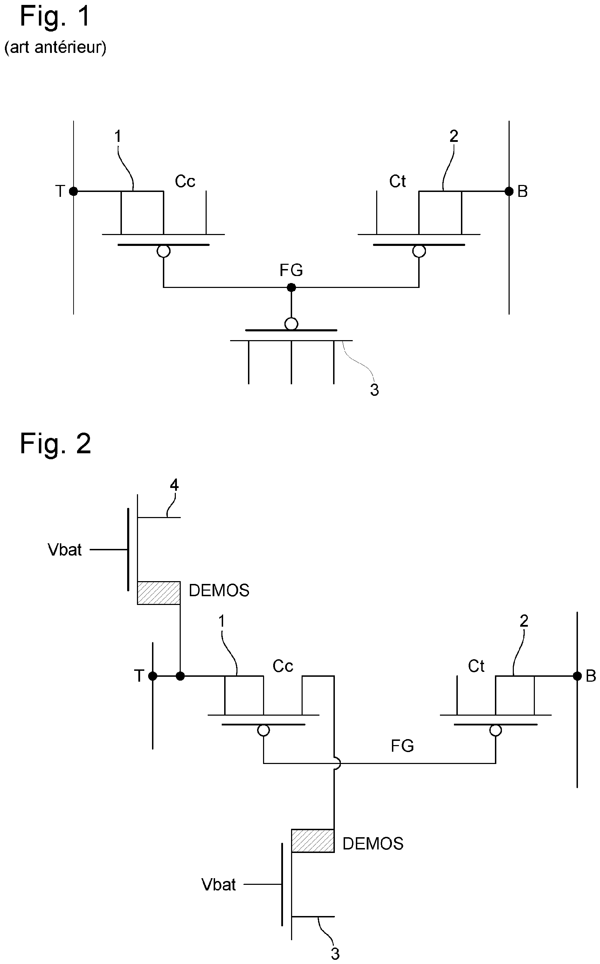

Comme représenté schématiquement à la figure 1, le circuit électronique comprend au moins une structure mémoire du type effaçable électriquement (EE). La structure mémoire peut comprendre au moins un condensateur à grille flottante FG. Cependant, cette structure mémoire à grille flottante est composée plutôt d'un premier condensateur 1 à capacité de couplage Ce et d'un second condensateur 2 à capacité de couplage Ct. Chaque condensateur est réalisé dans un même substrat semi-conducteur qui peut être de type P ou de type N. Généralement les deux condensateurs 1 et 2 sont réalisés dans un même substrat semi-conducteur de type P avec tous les autres éléments du circuit électronique intégrés. Les deux condensateurs 1 et 2 à grille flottante sont reliés l'un à l'autre en série par leur grille flottante FG commune.

Dans cette structure mémoire du circuit électronique de la figure 1, la grille flottante dénommée FG est chargée par effet tunnel en couplant une tension de programmation appliquée sur une première borne d'entrée T du premier condensateur 1 ou sur une seconde borne d'entrée B du second condensateur 2. Généralement, la charge par effet tunnel s'opère par la seconde borne d'entrée B du second condensateur 2 de dimension inférieure au premier condensateur 1. La tension ainsi programmée sur cette grille flottante FG est ensuite lue par le transistor de lecture PMOS 3 (T_read), dont la grille est reliée à la grille flottante FG. La structure globale qui est représentée en mode asymétrique sur cette figure 1, utilise des transistors de type PMOS 1 et 2 pour implémenter les premier et second condensateurs 1 et 2 à capacités Cc et Ct. La structure est généralement implémentée en mode différentiel. Afin de maximiser le couplage entre la première borne T et la grille flottante FG, le transistor de lecture 3 (à capacité parasite) ainsi que le second condensateur 2 à effet tunnel à capacité Ct sont dimensionnés avec une taille la plus faible possible par rapport au premier condensateur 1 de couplage Cc. Par conséquent, pour une taille donnée de l'ensemble Cc - Ct - T_read, l'offset de lecture, qui est l'offset de la tension de seuil et du courant mesuré, est inversement proportionnel à la taille du transistor de lecture. Sachant que la tension mémorisée décroît avec le temps, cet offset important limite la durée de rétention de la mémoire, en ajoutant une incertitude statistique sur la tension mémorisée, ce qui constitue un inconvénient d'une telle structure de mémoire.

### Résumé de l'invention

Pour ce faire, la présente invention concerne un circuit électronique à structure mémoire à grille flottante en configurant un des condensateurs à capacité de couplage à grille flottante de grande dimension sous la forme d'un transistor de lecture pour éviter d'utiliser un autre transistor de lecture spécifique comme décrit dans la revendication indépendante 1.

Des formes particulières de réalisation du circuit électronique à structure mémoire à grille flottante sont définies dans les revendications dépendantes 2 à 13.

Un avantage de la présente invention réside dans le fait qu'il est configuré un condensateur de grande dimension à capacité de couplage de la structure mémoire à grille flottante sous la forme principalement d'un transistor de lecture de la structure mémoire. Il est ensuite plus simple d'interfacer ce transistor en mode de lecture au moyen de transistors de protection, car les charges capacitives parasites de ces transistors de protection n'influencent pas le couplage des bornes d'entrée de la structure mémoire sur la grille flottante en tant que tel. Comme la taille du transistor de lecture (créée sur la base du condensateur à capacité de couplage Cc) est maintenant importante, l'offset de lecture est réduit de manière significative. De plus, la suppression du petit transistor de lecture de l'art antérieur augmente substantiellement le couplage capacitif selon le rapport capacitif des deux condensateurs donné.

Un avantage de la présente invention est de pouvoir diminuer les problèmes d'offset dans la lecture d'une structure mémoire permanente de type effaçable électriquement dans une technologie à simple substrat poly-silicium.

### Brève description des figures

Les buts, avantages et caractéristiques d'un circuit électronique adapté pour charger ou lire une structure mémoire à grille flottante faisant partie du circuit électronique apparaîtront mieux dans la description suivante de manière non limitative en regard des dessins sur lesquels :
- la figure 1 est une représentation schématique d'une structure mémoire à grille flottante selon l'art antérieur,
- la figure 2 est une représentation schématique d'une structure mémoire à grille flottante d'un circuit électronique adapté pour charger ou lire ladite structure de la présente invention dans laquelle un condensateur de couplage est utilisé comme transistor de lecture,
- la figure 3 est une représentation plus détaillée d'une première forme d'exécution d'un circuit électronique adapté pour charger ou lire au moins une structure mémoire à grille flottante dudit circuit électronique, et
- la figure 4 est une représentation plus détaillée d'une seconde forme d'exécution d'un circuit électronique adapté pour charger ou lire deux structures mémoire à grille flottante inversement connectées en parallèle dudit circuit électronique.

### Description détaillée de l'invention

Le circuit électronique ayant une structure mémoire à grille flottante de la présente invention permet d'avoir un couplage amélioré pour lire ou charger la structure mémoire à grille flottante. De plus, il est observé lors du fonctionnement du circuit, une diminution des problèmes d'offsets dans la lecture d'une telle structure mémoire.

À la figure 2, il est représenté de manière schématique principalement la structure mémoire à grille flottante du circuit électronique simplifié par rapport à l'art antérieur montré à la figure 1 décrite ci-dessus. Le premier condensateur 1 à capacité de couplage Ce de grande dimension est converti en transistor de type MOS. De cette manière, il est simple d'interfacer ce transistor en mode lecture à l'aide également de transistors de protection non représentés, car les charges capacitives parasites de ces transistors de protection n'influencent absolument pas le couplage de la première borne d'entrée T ou de la seconde borne d'entrée B sur la grille flottante FG.

Étant donné que le circuit électronique à structure mémoire à grille flottante est intégré de préférence dans un substrat silicium de type P, le premier condensateur 1 est converti en transistor PMOS de lecture. Les bornes de source et substrat de ce transistor PMOS sont reliées à la première borne d'entrée T, et la borne de drain reliée pour lire l'information du nouveau transistor de lecture avec la grille flottante FG programmée précédemment à une tension définie. La programmation de la grille flottante FG sera principalement réalisée par l'intermédiaire du second condensateur à capacité de couplage Ct. Une tension de programmation, qui peut aller jusqu'à près de 8 V voire plus, permettra de programmer une tension définie par l'intermédiaire du second condensateur de petite taille Ct par effet tunnel sur la grille flottante FG ou en utilisant l'effet d'injection d'électrons chauds. Dans le cas présent, il sera plutôt utilisé la programmation par l'effet tunnel à travers au moins une couche isolante pour charger la grille flottante commune FG aux deux condensateurs 1 et 2, Cc et Ct.

Comme le premier condensateur 1 converti en transistor de lecture est de grande dimension, cela permet de réduire notablement l'offset de lecture. Le second condensateur 2 de petite taille à capacité de couplage Ct est relié dans un même circuit intégré à la grille flottante FG du premier condensateur 1 à grande capacité de couplage Cc. Ce second condensateur 2 peut être réalisé selon une structure de transistor PMOS avec la source et le substrat reliés à la seconde borne d'entrée B et par contre le drain laissé sans connexion. De plus, avec la suppression du précédent transistor de lecture de l'art antérieur, cela permet de former une paire différentielle de lecture et d'augmenter substantiellement le couplage au rapport capacitif Cc/Ct donné.

Ainsi, le premier condensateur 1 de la structure mémoire est converti en un transistor de type PMOS pour être directement un transistor de lecture de l'état de charge de la grille flottante de la structure mémoire afin d'éviter l'utilisation d'un transistor de lecture originel comme présenté à la figure 1, ayant une capacité parasite associée, et de manière à accroître le facteur de couplage d'une tension de programmation (Vprog) et ainsi pour diminuer la valeur de la tension de programmation (Vprog) nécessaire pour obtenir une tension de grille flottante (FG) donnée.

À titre informatif, on peut donner certaines valeurs de grandeur des condensateurs 1 et 2 utilisés et des différentes tensions de batterie Vbat, d'alimentation Vdd et de programmation Vprog de la structure mémoire à grille flottante FG. Le premier condensateur 1 peut être réalisé sur une largeur w égale à par exemple 2,24 µm et sur une longueur l égale à par exemple 1,75 µm, ce qui donne une surface au niveau de la grille flottante de l'ordre de 3,92 µm² approchant 4 µm². Par contre, le second condensateur 2 peut être réalisé sur une largeur w égale à par exemple 0,65 µm et sur une longueur l égale à par exemple 0,5 µm, ce qui donne une surface au niveau de la grille flottante de l'ordre de 0,325 µm². Le rapport de surface entre les deux condensateurs Cc et Ct intégrés du circuit électronique est donc supérieur à 10 fois et dans le cas présent même à 12 fois supérieur. Cela montre la grande différence dimensionnelle du premier condensateur par rapport au second condensateur. La tension d'alimentation Vdd du circuit électronique intégré de tous ces composants nécessaires à la lecture et à la charge de la structure mémoire à grille flottante qui fait partie du circuit électronique peut être définie de l'ordre de 1,2 V, alors que la tension de batterie Vbat utilisée pour polariser certains transistors reliés aux première et seconde bornes d'entrée T et B de la structure mémoire, peut être de l'ordre de 3,6 V. La tension de programmation Vprog de la structure mémoire notamment par l'intermédiaire de la seconde borne d'entrée B par le second condensateur 2, peut être de l'ordre de 7,4 V ou pouvant aller même jusqu'à presque 9 V, en phase de programmation, pendant une durée de programmation pouvant aller jusqu'à 100ms par impulsion. Bien entendu une fois que la programmation a été effectuée sur la grille flottante FG de la structure mémoire, la borne de tension de programmation Vprog peut être laissée flottante. La tension de batterie peut être abaissée à 1,2 V égale à la tension d'alimentation Vdd. Dans certains cas de figure, lorsque la grille flottante FG est chargée, la tension d'alimentation Vdd peut être même placée au niveau de la masse Vss provisoirement en phase de lecture de la tension de grille flottante FG.

Il est encore à noter de manière générale que lorsque la tension de grille flottante programmée devient suffisamment faible (typiquement dans la plage de 1 mV), le courant d'effet tunnel d'un oxyde mince devient comparable au courant d'effet tunnel d'un oxyde épais à 1 V. Si l'opération de lecture est effectuée rapidement (en exposant la grille au VT uniquement pendant une très courte durée de lecture, ou en compensant par une exposition similaire au -VT), les dispositifs à oxyde mince pourraient être utilisés pour une rétention de longue durée. Des amplificateurs de détection différentiels à mise à zéro automatique seraient alors nécessaires pour détecter correctement la très faible différence de tension de la cellule binaire. L'avantage est qu'une tension de programmation typique de 5 V est alors suffisante pour programmer la structure.

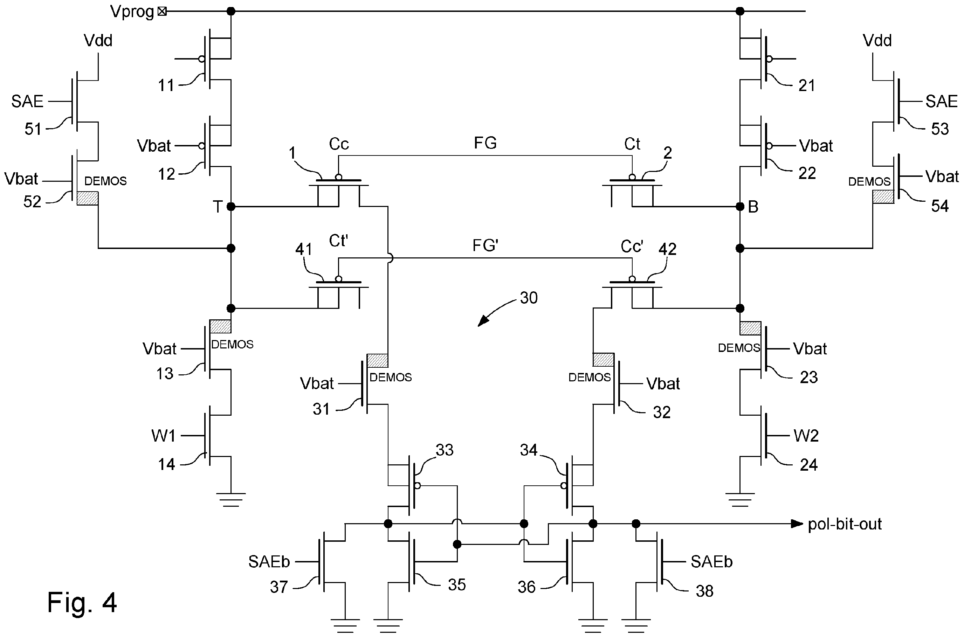

À la figure 2, il est encore représenté un transistor NMOS 3 avec un potentiel de source d'alimentation Vbat sur sa grille en sortie du transistor PMOS 1 de lecture, et un autre transistor NMOS 4 en liaison à la première borne d'entrée T, du nouveau transistor de lecture 1. Ces deux transistors 3 et 4 peuvent être également des transistors de type N DEMOS ("Drain-Extended-MOS" en terminologie anglaise). Grâce à ces transistors DEMOS, cela permet de protéger le verrou ("latch" en terminologie anglaise) expliqué à la figure 4 ci-après et l'accès à la tension d'alimentation Vdd de la tension de programmation Vprog, qui peut être plus élevée lors d'une phase de programmation. Des transistors DEMOS spéciaux avec un drain entouré d'un chevauchement de caisson Nwell de 0,3 µm, ont été utilisés pour implémenter les transistors cascode, afin d'augmenter le claquage inverse et d'éviter le courant de rupture indésirable correspondant vers Vss et de permettre une tension Vprog pouvant aller jusqu'à +9 V.

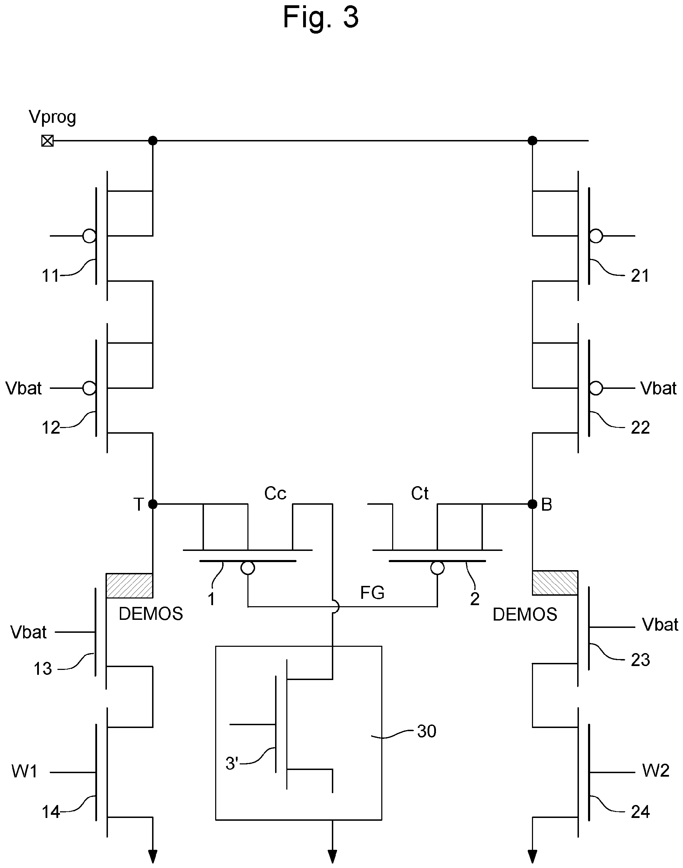

À la figure 3, il est représenté une première forme d'exécution du circuit électronique pour lire ou charger une structure mémoire à grille flottante faisant partie du circuit électronique. La structure mémoire décrite en référence à la figure 2 ci-dessus est bien représentée maintenant en connexion avec des transistors montés en cascode depuis les bornes d'entrée T et B. Il est ainsi représenté les deux condensateurs 1 et 2 de la structure mémoire en série entre les deux bornes d'entrée T et B. Le premier condensateur 1 de grande dimension à capacité de couplage Ce et le second condensateur 2 à capacité de couplage Ct sont reliés par l'intermédiaire de la grille flottante FG commune.

Généralement dans l'utilisation du circuit électronique intégré avec la structure mémoire à grille flottante FG, il y a tout d'abord une phase de programmation de la structure mémoire, et après cette programmation de la structure mémoire, il y a sur requête une ou plusieurs phases de lecture successives échelonnées dans le temps de l'état de lecture de la structure mémoire à grille flottante FG. Dans chaque phase de lecture avec la structure mémoire programmée, le premier condensateur 1 de grande dimension est converti en transistor de type PMOS pour servir de transistor de lecture de la charge accumulée sur la grille flottante. À ce titre, une unité de lecture 30 est reliée au drain de ce transistor PMOS de manière à déterminer l'état de charge de la structure mémoire à grille flottante. De manière simplifiée il est représenté encore un transistor complémentaire 3' de type NMOS avec son drain relié au drain du transistor PMOS du premier condensateur 1 Ce en phase de lecture de la charge sur la grille flottante FG dans l'unité de lecture 30. Ce transistor 3' peut être également du même type que le transistor 3 DEMOS de la figure 2.

Le circuit électronique représenté à la figure 3, est maintenant décrit avec tout l'agencement des transistors nécessaires à sa fonctionnalité que ce soit pour la programmation de la structure mémoire ou de la lecture ou de la charge de la structure mémoire à grille flottante. Comme indiqué ci-dessus, il est utilisé de préférence des paires de transistors montés en cascode depuis les bornes d'entrée T et B des condensateurs à grille flottante FG. Tout d'abord pour la programmation de la grille flottante FG, deux transistors montés en série de type PMOS 21 et 22 relient d'un côté une borne de programmation de tension de programmation Vprog, et de l'autre côté la seconde borne d'entrée B de la structure mémoire à grille flottante. Dans ce cas de figure, une programmation de la grille flottante FG peut être effectuée à travers le second condensateur 2 à capacité Ct de petite taille par effet tunnel. Le premier transistor PMOS 21 est relié par la source et le substrat à la borne de programmation Vprog, alors que le drain du premier transistor PMOS 21 est relié à la source et substrat du second transistor PMOS 22, dont la grille est polarisée par une tension de batterie Vbat. Le premier transistor PMOS 21 servant de commutateur pour relier la borne de programmation à la seconde borne d'entrée B. Si la tension sur la grille du premier transistor PMOS est au moins à une tension équivalente ou inférieure à la tension de batterie Vbat, cela signifie qu'aussi bien le premier transistor PMOS 21 que le second transistor PMOS 22 sont rendus conducteurs pour pouvoir effectuer la programmation de la grille flottante FG de la structure mémoire par l'intermédiaire du second condensateur 2 de la structure mémoire.

Deux transistors montés en série de type PMOS 11 et 12 relient d'un côté la borne de programmation de tension de programmation Vprog, et de l'autre côté la première borne d'entrée T de la structure mémoire à grille flottante. Le premier transistor PMOS 11 est relié par la source et le substrat à la borne de programmation Vprog, alors que le drain du premier transistor PMOS 11 est relié à la source et substrat du second transistor PMOS 12, dont la grille est polarisée par une tension de batterie Vbat. A la différence du premier transistor PMOS 21, le premier transistor PMOS 11 est rendu non conducteur pour ne pas avoir de liaison avec la borne de tension de programmation Vprog. Le drain du second transistor PMOS 12 est relié à la première borne d'entrée T du premier condensateur 1.

Depuis la première borne d'entrée T de la structure mémoire, une paire de transistors en série de type NMOS est prévue. Le troisième transistor NMOS 13 est relié par son drain à la première borne d'entrée T, alors que la borne de source est reliée à la borne de drain du quatrième transistor NMOS 14, dont la borne de source est reliée de préférence directement à la masse. La grille du troisième transistor NMOS 13 est polarisée par une tension de batterie Vbat, alors que la grille du quatrième transistor NMOS 14 est contrôlée par un premier signal de commande W1.

Depuis la seconde borne d'entrée B de la structure mémoire, une autre paire de transistor en série de type NMOS est prévue. Le troisième transistor NMOS 23 est relié par son drain à la seconde borne d'entrée B, alors que la borne de source est reliée à la borne de drain du quatrième transistor NMOS 24, dont la borne de source est reliée de préférence directement à la masse. La grille du troisième transistor NMOS 23 est polarisée par une tension de batterie Vbat, alors que la grille du quatrième transistor NMOS 24 est contrôlée par un second signal de commande W2.

De préférence, les troisièmes transistors NMOS 13 et 23 sont des transistors de type DEMOS (Drain-Extended-MOS).

La figure 4 présente une seconde forme d'exécution d'un circuit électronique adapté pour charger ou lire deux structures mémoire à grille flottante FG et FG' inversement connectées en parallèle dudit circuit électronique. Le principe de fonctionnement de ce type de structure mémoire se base sur une structure différentielle de deux grilles flottantes FG et FG', qui sont connectées chacune à deux condensateurs en série à savoir un premier condensateur 1 à capacité de couplage Ce importante lié à la première borne d'entrée T, et un second condensateur 2 à faible capacité de couplage Ct adapté pour une programmation de la première grille flottante FG par effet tunnel à travers la seconde borne d'entrée B. Le premier condensateur 1 de grande dimension est directement adaptable pour servir de premier transistor de lecture de type PMOS en reliant sa borne de drain à une borne de drain d'un premier transistor de type NMOS 31 de l'unité de lecture 30. Bien entendu ce premier transistor 31 peut être avantageusement un premier transistor DEMOS.

Un troisième condensateur 42 à capacité de couplage Cc' importante est lié à la seconde borne d'entrée B, et est adaptable pour servir de second transistor de lecture de type PMOS en reliant sa borne de drain à une borne de drain d'un second transistor de type NMOS 32 de l'unité de lecture 30. Bien entendu, ce second transistor 32 de l'unité de lecture 30, peut être avantageusement un second transistor DEMOS. Un quatrième condensateur 41 à faible capacité de couplage Ct' est lié à la première borne d'entrée T, et est adaptable pour une programmation de la seconde grille flottante FG' par effet tunnel à travers la première borne d'entrée T.

Les condensateurs 1, 2, 41, 42 de couplage Cc, Ct, Cc' et Ct' peuvent être de préférence réalisés sous la forme de transistors PMOS à oxyde épais (par exemple d'une épaisseur de l'ordre de 60 Angstrom). Pour ce faire, il est de préférence utilisé les connexions source et grille, car la connexion de drain n'est pas utilisée si pas d'utilisation en tant que transistor de lecture.

Il est encore à noter, que le terminal de drain non utilisé du transistor réalisant le condensateur à capacité de couplage Cc et Cc' la plus importante peut être utilisé pour créer un transistor de lecture de forte taille, et ainsi supprimer comme dans l'art antérieur le tout petit transistor de lecture standard. De plus il est maximisé la fonction de couplage du condensateur à capacité la plus importante en permettant de supprimer la charge parasite du transistor de lecture originelle. Comme le transistor de lecture est ainsi agrandi, l'erreur d'offset du circuit électronique de lecture est réduite. Cela permet d'augmenter la durée de rétention de la mémoire dans laquelle les potentiels de grille flottante FG et FG' diminue lentement dans le temps par des fuites. De plus, comme le couplage vers grille flottante FG/FG' de l'impulsion de programmation (haute tension appliquée sur les bornes d'entrée T ou B) est amélioré, la tension programmée également maximisée.

Il est encore à noter que les paires de transistors PMOS, DEMOS et NMOS 11, 12, 13, 14, 21, 22, 23, 24, qui sont identiques à ceux déjà décrits en référence à la figure 3 ne seront pas décrits à nouveau en référence à la figure 4.

Comme on peut encore le remarquer sur la figure 4, l'unité de lecture 30 comprend encore en dessous des premier et second transistors 31 et 32, un ensemble à verrou susceptible de fournir en sortie un signal dénommé pol_bit_out, qui renseigne sur l'état de programmation sur chacune des grilles flottantes FG et FG'.

À ce titre, il est prévu un troisième transistor PMOS 33 dont les bornes de source et substrat sont reliées à la borne de source du premier transistor 31 NMOS ou DEMOS, et dont la borne de drain est reliée à une borne de drain d'un cinquième transistor NMOS 35. Le cinquième transistor 35 a sa borne de source directement liée à la masse. Les bornes de grille des troisième et cinquième transistors 33 et 35 sont reliées l'une à l'autre, ce qui permet de former un premier inverseur.

Il est encore prévu un quatrième transistor PMOS 34 dont les bornes de source et substrat sont reliées à la borne de source du second transistor 32 NMOS ou DEMOS, et dont la borne de drain est reliée à une borne de drain d'un sixième transistor NMOS 36. Le sixième transistor 36 à sa borne de source directement liée à la masse. Les bornes de grille des quatrième et sixième transistors 34 et 36 sont reliées l'une à l'autre, ce qui permet de former un second inverseur.

Il est encore à noter que les bornes de grille du troisième transistor 33 et du cinquième transistor 35 sont reliées à la borne de drain du quatrième transistor 34 et à la borne de drain du sixième transistor 36, ce qui permet de fournir en sortie au moins un signal de sortie pol-bit-out. De même, les bornes de grille du quatrième transistor 34 et du sixième transistor 36 sont reliées à la borne de drain du troisième transistor 33 et à la borne de drain du cinquième transistor 35.

Il est encore prévu de relier un premier transistor NMOS 37 d'un mode de repos au cinquième transistor NMOS 35. La borne de drain du premier transistor 37 du mode de repos, dont la borne de source est reliée à la masse, est reliée à la borne de drain du cinquième transistor 35. De même, il est prévu de relier encore un second transistor NMOS 38 d'un mode de repos par sa borne de drain à la borne de drain du sixième transistor NMOS 36. La borne de source de ce second transistor NMOS 38 est reliée à la masse. De cette manière s'il est souhaité avoir un mode de repos, la borne de grille des premier et second transistors 37 et 38 est à une tension suffisante fournie par le signal SAEb pour les rendre conducteurs et ainsi passer en mode de repos.

Il est encore prévu de connecter entre une tension d'alimentation Vdd et la première borne d'entrée T de la structure mémoire, un premier transistor NMOS 51 par une borne de drain à une borne de tension d'alimentation Vdd et par une borne de source à une borne de drain d'un second transistor DEMOS 52, dont la borne de source est reliée à la première borne d'entrée T. Le premier transistor 51 est commandé sur sa borne de grille par un signal SAE, alors que la borne de grille du second transistor 52 est commandée par le signal de la tension de batterie Vbat.

De même, il est encore prévu de connecter entre une tension d'alimentation Vdd et la seconde borne d'entrée B de la structure mémoire, un troisième transistor NMOS 53 par une borne de drain à une borne de tension d'alimentation Vdd et par une borne de source à une borne de drain d'un quatrième transistor DEMOS 54, dont la borne de source est reliée à la seconde borne d'entrée B. Le troisième transistor 53 est commandé sur sa borne de grille par un signal SAE, alors que la borne de grille du quatrième transistor 54 est commandée par le signal de la tension de batterie Vbat.

Plusieurs variantes de réalisation du circuit électronique peuvent être prévues pour pouvoir charger ou lire une structure mémoire à grille flottante faisant partie du circuit électronique dans les limites de portée des revendications.

## Revendications

1. Circuit électronique disposant d'une structure mémoire à grille flottante, qui comprend depuis une première borne d'entrée (T) un premier condensateur (1) à grille flottante (FG) de grande dimension, et depuis une seconde borne d'entrée (B) un second condensateur (2) à grille flottante (FG) de dimension inférieure au premier condensateur (1), le premier condensateur (1) étant relié en série par l'intermédiaire de sa grille flottante (FG) à la grille flottante (FG) du second condensateur (2), ledit circuit électronique étant agencé pour lire et charger la structure mémoire à grille flottante, **caractérisé en ce que** le premier condensateur est converti sous la forme d'un transistor de type MOS pour servir directement de transistor de lecture de la structure mémoire à grille flottante.

2. Circuit électronique selon la revendication 1, **caractérisé en ce que** le circuit électronique est intégré avec la structure mémoire à grille flottante dans un substrat silicium de type P, et **en ce que** le premier condensateur (1) de la structure mémoire est converti en un transistor de type PMOS avec une source liée au substrat relié à la première borne d'entrée (T) de la structure mémoire, et un drain permettant la lecture de l'état de charge de la structure mémoire en liaison à une unité de lecture (30).

3. Circuit électronique selon la revendication 2, **caractérisé en ce que** le premier condensateur (1) à capacité de couplage (Cc) à grande dimension configuré en transistor de lecture permet d'interfacer ce transistor en mode lecture au moyen de transistors de protection, où les charges capacitives parasites de ces transistors de protection n'influencent pas le couplage de la première borne d'entrée (T) ou de la seconde borne d'entrée (B) sur la grille flottante (FG), et **en ce que** la dimension du transistor de lecture permet de réduire l'offset de lecture de manière significative.

4. Circuit électronique selon la revendication 2, **caractérisé en ce que** le premier condensateur (1) de la structure mémoire est converti en un transistor de type PMOS pour être directement un transistor de lecture de l'état de charge de la grille flottante de la structure mémoire afin d'éviter l'utilisation d'un transistor de lecture originel ayant une capacité parasite associée, de manière à accroître le facteur de couplage d'une tension de programmation (Vprog) et ainsi pour diminuer la valeur de la tension de programmation (Vprog) nécessaire pour obtenir une tension de grille flottante (FG) donnée.

5. Circuit électronique selon l'une des revendications 1 et 2, **caractérisé en ce que** le rapport de surface entre les deux condensateurs Cc et Ct intégrés du circuit électronique est supérieur à 10 fois.

6. Circuit électronique selon la revendication 5, **caractérisé en ce que** le premier condensateur (1) est réalisé sur une largeur w égale à 2,24 µm et sur une longueur l égale à 1,75 µm, ce qui donne une surface au niveau de la grille flottante de l'ordre de 3,92 µm², et **en ce que** le second condensateur (2) est réalisé sur une largeur w égale à 0,65 µm et sur une longueur l égale à 0,5 µm, ce qui donne une surface au niveau de la grille flottante de l'ordre de 0,325 µm², qui est plus de 12 fois inférieure à la surface du premier condensateur (1).

7. Circuit électronique selon l'une des revendications 1 à 4, **caractérisé en ce qu'**une unité de lecture (30) est reliée au drain du transistor PMOS (1) de manière à déterminer l'état de charge de la structure mémoire à grille flottante (FG).

8. Circuit électronique selon la revendication 7, **caractérisé en ce qu'**un premier transistor de type N DEMOS (3, 3') de l'unité de lecture (30) est relié par un drain au drain du transistor PMOS (1).

9. Circuit électronique selon l'une des revendications 1 et 2, **caractérisé en ce que** pour effectuer une programmation de la grille flottante (FG) de la structure mémoire, deux transistors (21, 22) montés en série de type PMOS relient d'un côté une borne de programmation de tension de programmation (Vprog), et de l'autre côté la seconde borne d'entrée (B) de la structure mémoire à grille flottante (FG) pour effectuer une charge à travers le second condensateur (2) à capacité (Ct) de petite taille par effet tunnel, **en ce que** le premier transistor PMOS (21) est relié par une source et un substrat à la borne de programmation (Vprog), alors qu'un drain du premier transistor PMOS (21) est relié à une source et un substrat du second transistor PMOS (22), dont une grille est polarisée par une tension de batterie (Vbat), et **en ce que** le premier transistor PMOS (21) sert de commutateur pour relier la borne de programmation à la seconde borne d'entrée (B), si la tension sur la grille du premier transistor PMOS (21) est au moins à une tension équivalente ou inférieure à la tension de batterie (Vbat) inférieure à une tension de programmation (Vprog).

10. Circuit électronique selon l'une des revendications 1 et 2, **caractérisé en ce qu'**il comprend deux transistors montés en série de type PMOS (11, 12) reliant d'un côté la borne de programmation de tension de programmation (Vprog), et de l'autre côté la première borne d'entrée (T) de la structure mémoire à grille flottante (FG), **en ce que** le premier transistor PMOS (11) est relié par une source et un substrat à la borne de programmation (Vprog), alors qu'un drain du premier transistor PMOS (11) est relié à une source et un substrat du second transistor PMOS (12), dont une grille est polarisée par une tension de batterie (Vbat), et **en ce que** le premier transistor PMOS (11) peut être contrôlé sur une grille pour être rendu conducteur ou de préférence non conducteur pour ne pas avoir de liaison avec la borne de tension de programmation (Vprog) si un drain du second transistor PMOS (12) est relié à la première borne d'entrée (T) du premier condensateur 1 à grande capacité de couplage.

11. Circuit électronique selon l'une des revendications 1 et 2, **caractérisé en ce qu'**il comprend deux paires de transistors de type N (13, 14; 23, 24) montés en série en cascode respectivement depuis les bornes d'entrée (T, B) et reliée à une borne de masse (Vss), **en ce que** le premier transistor (13, 23) de chaque paire est un transistor DEMOS polarisé sur une grille par une tension de batterie (Vbat), alors que le second transistor (14, 24) de chaque paire est un transistor de type NMOS respectivement contrôlé sur une grille par un signal de contrôle (W1, W2).

12. Circuit électronique selon l'une des revendications 1 à 7, **caractérisé en ce qu'**il comprend deux structures mémoire à grille flottante (FG, FG') inversement connectées en parallèle entre la première borne d'entrée (T) et la seconde borne d'entrée (B), **en ce que** depuis la première borne d'entrée (T), il est prévu le premier condensateur (1) à première grille flottante (FG) de grande dimension, **en ce que** depuis la seconde borne d'entrée (B), il est prévu le second condensateur (2) à première grille flottante (FG) de dimension inférieure au premier condensateur (1), **en ce que** depuis la seconde borne d'entrée (B), il est prévu un troisième condensateur (42) à seconde grille flottante (FG') de grande dimension, et **en ce que** depuis la première borne d'entrée (T), il est prévu un quatrième condensateur (41) à seconde grille flottante (FG') de dimension inférieure au troisième condensateur (42).

13. Circuit électronique selon la revendication 12, **caractérisé en ce que** l'unité de lecture (30) comprend un premier transistor DEMOS (31) relié par un drain au drain du premier transistor PMOS de lecture du premier condensateur (1), et un second transistor DEMOS (32) relié par un drain à un drain d'un second transistor PMOS de lecture du troisième condensateur (42), et **en ce que** l'unité de lecture (30) est configurée pour fournir en sortie au moins un signal (pol-bit-out) de l'état de charge des grilles flottantes.
